# EUROPÄISCHE PATENTSCHRIFT

(11) **EP 2 721 725 B1**
(45) Veröffentlichungstag und Bekanntmachung des Hinweises auf die Patenterteilung: **25.11.2015**
(21) Anmeldenummer: 12735889.3
(22) Anmeldetag: 18.07.2012
(51) Int. Cl.: H02K 55/04, H01F 13/00, H01L 39/10

(54) **ELEKTRISCHE MASCHINE UND VERFAHREN ZU DEREN BETRIEB**
ELECTRICAL MACHINE AND METHOD FOR OPERATING IT
MOTEUR ÉLECTRIQUE ET PROCÉDÉ POUR FAIRE FONCTIONNER LE MOTEUR ÉLECTRIQUE

(30) Priorität: 25.07.2011 DE 102011079725
(43) Veröffentlichungstag der Anmeldung: 23.04.2014
(73) Patentinhaber: Siemens Aktiengesellschaft, 80333 München (DE)
(72) Erfinder: FRANK, Michael, 91080 Uttenreuth (DE); FRAUENHOFER, Joachim, 90425 Nürnberg (DE); GRUNDMANN, Jörn, 91091 Großenseebach (DE); HERKERT, Werner, 91058 Erlangen (DE); KUMMETH, Peter, 91074 Herzogenaurach (DE); NICK, Wolfgang, 90419 Nürnberg (DE); SCHMIDT, Heinz, 91096 Möhrendorf (DE); VAN HASSELT, Peter, 91058 Erlangen (DE)
(86) Internationale Anmeldenummer: PCT/EP2012/064088
(87) Internationale Veröffentlichungsnummer: WO 2013/014043

(56) Entgegenhaltungen:
- JP-A- H07 211 546
- US-A1- 2007 052 304
- US-A1- 2008 252 404
- US-A1- 2010 283 318

## Beschreibung

Die Erfindung betrifft eine elektrische Maschine, umfassend als Bauteile einen Stator und einen gegen den Stator drehbaren Rotor, wobei die Pole eines Bauteils, insbesondere des Rotors, supraleitende Spulen zur Erzeugung eines magnetischen Flusses umfassen. Daneben betrifft die Erfindung ein Verfahren zum Betrieb einer solchen elektrischen Maschine.

Elektrische Maschinen sind in verschiedensten Ausgestaltungen für die verschiedensten Anwendungen im Stand der Technik weithin bekannt. Zu den bekannten elektrischen Maschinen gehört auch eine permanentmagneterregte Maschine, bei der, insbesondere am Rotor, Permanentmagneten eingesetzt werden, um die Pole zu realisieren. Allerdings ist bei der Verwendung von Permanentmagneten der maximal erreichbare magnetische Fluss des Rotors durch die Permanentmagneten limitiert. Wünschenswert ist es, einen höheren magnetischen Fluss an den Polen zur Verfügung zu stellen, so dass leistungsfähigere Maschinen entwickelt werden können.

Bekannt sind auch elektrische Maschinen, bei denen eine im Vergleich zu Permanentmagnetmaschinen erhöhte magnetische Flussdichte und damit eine erhöhte Leistungsdichte durch den Einsatz von elektrischen Spulen realisiert wurde. Insbesondere sind hierbei sogenannte supraleitende Maschinen zu nennen, welche supraleitende Polwicklungen, die entsprechend gekühlt werden, aufweisen. Hiermit lassen sich besonders hohe Leistungsdichten erzielen.

Bei solchen supraleitenden Maschinen, beispielsweise Hochtemperatursupraleiter-Synchronmotoren, Hochtemperatursupraleiter-Generatoren oder Synchron-Kondensoren müssen die supraleitenden Polwicklungen, insbesondere als Rotorwicklungen ausgeführt, gekühlt und kontinuierlich mit Strom versorgt werden. Bei Ausfall des Erregerstroms, beispielsweise durch Ausfall der Stromversorgung, oder bei Ausfall des Kühlsystems und dadurch verursachtes Aufwärmen der Rotorwicklungen über die kritische Temperatur der Rotorwicklungen ist der Betrieb der supraleitenden Maschine nicht mehr möglich. Derartiges ist insbesondere dann kritisch, wenn die supraleitende Maschine, beispielsweise auf einem Schiff, als relevante Energiequelle oder dergleichen eingesetzt wird. Verschiedene Dokumente, der unter US 2007052304, US 2010283318, US 2008252404 und JPH07211546, empfehlen das "Einfrieren" magnetischen Flusses in Hochtemperatursupraleitern.

Der Erfindung liegt daher die Aufgabe zugrunde, eine dem gegenüber verbesserte supraleitende Maschine anzugeben, mit welcher insbesondere höhere Leistungsdichten erzielt werden können und/oder die bei einem Ausfall des Erregerstroms oder des Kühlsystems eine erhöhte Betriebssicherheit bietet.

Zur Lösung dieser Aufgabe ist bei einer elektrischen Maschine der eingangs genannten Art erfindungsgemäß vorgesehen, dass in dem Pfad des magnetischen Flusses wenigstens ein Hochtemperatursupraleitermaterialblock mit einem diesem zugeordneten, zur zeitweisen Erhöhung der Temperatur des Hochtemperatursupraleitermaterialblocks über die kritische Temperatur des Materials des Hochtemperatursupraleitermaterialblocks bei supraleitender Spule ausgebildeten Heizmittel angeordnet ist.

Zunächst sei angemerkt, dass, obwohl die Erfindung auch dann, wenn die supraleitenden Wicklungen am Stator vorgesehen sind, realisiert werden kann, die folgenden Ausführungen sich in den meisten Fällen beispielhaft auf den Rotor als entsprechendes Bauteil beziehen. Dabei kann es sich bei dem Rotor sowohl um einen Innenläufer als auch um einen Außenläufer handeln. Die vorliegende Erfindung ist also für verschiedenste Arten des Aufbaus supraleitender Maschinen einsetzbar.

Die grundsätzliche Idee der vorliegenden Erfindung ist es also, neben der supraleitenden Spule (Polwicklung) auch wenigstens einen Hochtemperatursupraleitermaterialblock aus Hochtemperatursupraleiter-Bulkmaterial zu verwenden, in dem magnetischer Fluss der supraleitenden Spule sozusagen "eingefroren" werden kann. Die Polwicklungen werden also, gegebenenfalls neben der Nutzung zum Betrieb der Maschine, zur Aufmagnetisierung von an dem Bauteil zusätzlich angebrachten Hochtemperatursupraleiter-Bulkmaterial genutzt. Zur Magnetisierung des Hochtemperatursupraleitermaterials des Hochtemperatursupraleitermaterialblocks wird dieses mittels des Heizmittels kurzzeitig über seine kritische Temperatur erwärmt. Zur selben Zeit wird allerdings die supraleitende Spule unterhalb ihrer kritischen Temperatur gehalten und ist bestromt. Dadurch, dass der Hochtemperatursupraleitermaterialblock sich auf einer Temperatur oberhalb seiner kritischen Temperatur befindet, wird der magnetische Fluss der Spule nicht aus dem Hochtemperatursupraleitermaterialblock verdrängt, sondern er durchdringt das nun normal leitende Hochtemperatursupraleitermaterial. Wird nun das Heizmittel wieder abgeschaltet, so kühlt sich der Hochtemperatursupraleitermaterialblock wieder auf Temperaturen unterhalb seiner kritischen Temperatur ab. Hierbei wird der magnetische Fluss im Hochtemperatursupraleiter-Bulkmaterial verankert ("gepinnt") und somit "eingefroren". Wird nun der Erregerstrom durch die supraleitende Spule abgeschaltet, bleibt der im Hochtemperatursupraleitermaterialblock "eingefrorene" und somit gespeicherte magnetische Fluss erhalten und weiterhin nutzbar, solange die Temperatur des Hochtemperatursupraleitermaterials niedrig genug bleibt. Dies gilt selbstverständlich auch bei einem späteren Ausfall des Erregerstroms, so dass die Maschinen in einem solchen Fall quasi als "permanentmagneterregte Maschine" weiter betrieben werden kann.

Dies ist zunächst, insbesondere, wenn der Hochtemperatursupraleitermaterialblock zusätzlich vorgesehen wird, im Hinblick auf die Ausfallsicherheit einer solchen Maschine sehr vorteilhaft. Während nämlich üblicherweise supraleitende Spulen aus einem Hochtemperatursupraleiter-Bandleiter, beispielsweise einem YBCO-Bandleiter oder einem Bi2223-Bandleiter eine Betriebstemperatur von ungefähr 27 - 30 K aufweisen und bei höheren Temperaturen nur noch wesentlich geringere Ströme tragen können, ist die Flusslinienverankerung - abhängig vom Material - in einem Hochtemperatursupraleiter-Bulkmaterial auch bei höheren Temperaturen noch sehr effektiv, bei der Verwendung von YBCO beispielsweise noch bei Temperaturen bis zu ca. 65 K. Hierdurch wird zusätzliche Betriebszeit bei einem Ausfall der Kühlung gewonnen. Beim Ausfall des Erregerstroms und intakter Kühlung kann die Maschine sogar dauerhaft weiterbetrieben werden.

Insbesondere dann, wenn bei der konkreten Realisierung nur ein Teil des von den supraleitenden Spulen eingeschlossenen Volumens durch den wenigstens einen Hochtemperatursupraleitermaterialblock belegt wird, wird durch die vorliegende Erfindung letztlich eine "permanenterregte Maschine" realisiert, die zusätzlich noch eine regelbare Erregung durch Regelung der Bestromung der supraleitenden Spulen erlaubt.

Im Rahmen der vorliegenden Erfindung wird in eine supraleitende Maschine mit supraleitenden Polwicklungen mithin zusätzlich Hochtemperatursupraleiter-Bulkmaterial mit guten Pinningeigenschaften in Form des Hochtemperatursupraleitermaterialblocks integriert. Zur Magnetisierung des Hochtemperatursupraleiter-Bulkmaterials des Hochtemperatursupraleitermaterialblocks wird die ohnehin vorhandene supraleitende Spule (Polwicklung) verwendet. Hierbei wird der Effekt genutzt, dass Supraleiter im supraleitenden Zustand kein Magnetfeld eindringen lassen, im normal leitenden Zustand jedoch das Supraleiter-Material homogen vom Magnetfeld durchdrungen wird. Ist ein normalleitender Supraleiter vom Magnetfeld durchdrungen und wird anschließend durch Abkühlen in den supraleitenden Zustand gebracht, so wird das Magnetfeld im Supraleiter verankert.

Hierdurch ergeben sich eine Vielzahl von Vorteilen.

Zunächst kann, wie bereits dargelegt, bei Ausfall der Kühlung die supraleitende Maschine noch weiter betrieben werden. Dabei wird nicht nur der Spielraum bis zum Erreichen der kritischen Temperatur der supraleitenden Spule verfügbar, sondern darüber hinaus kann aufgrund des eingesetzten Hochtemperatursupraleitermaterials des Hochtemperatursupraleitermaterialblocks mit guten Pinningeigenschaften auch deutlich oberhalb einer Temperatur von beispielsweise 30 K die Maschine bis zum Erreichen einer Bulk-Temperatur von ungefähr 65 K weiter betrieben werden. Bei Ausfall der Erregereinrichtung für die supraleitende Spule ist die Maschine durch den im Hochtemperatursupraleitermaterialblock "eingefrorenen" magnetischen Fluss weiter betreibbar.

Bei einem Betrieb der Maschine mit aufmagnetisiertem Hochtemperatursupraleitermaterialblock und ohne Bestromung der supraleitenden Spule sind die Eigenschaften einer permanenterregten Maschine realisiert. Man benötigt in diesem Betriebszustand keine Regelung des Rotorstroms und kann die Maschine bei höheren Temperaturen betreiben. Durch die Verwendung der supraleitenden Spule zur Magnetisierung des Hochtemperatursupraleitermaterialblocks kann ein höheres Feld in diesen eingebracht werden, so dass die Hochtemperatursupraleiter-Permanentmagnetmaschine im Vergleich zur normalen Permanentmagnetmaschine kleiner und leichter realisiert werden kann.

Auch im Vergleich zu einer nur auf supraleitenden Spulen basierenden supraleitenden Maschine ist die Hochtemperatursupraleiter-Permanentmagnetmaschine kleiner und leichter. Bei gleichem Bauraum und Gewicht ist eine Hochtemperatursupraleiter-Permanentmagnetmaschine leistungsfähiger als die vorher genannten Maschinen. Der erfindungsgemäß erreichbare magnetische Fluss ist in Hochtemperatursupraleiter-Permanentmagnetmaschinen auch größer als der Fluss, der mit der in der Maschine vorhandenen Wicklung zur magnetischen Flusserzeugung erreichbar ist.

Die vorliegende Erfindung ermöglicht es im Übrigen auch, dass die Aufmagnetisierung bei bereits eingebautem Rotor beziehungsweise Bauteil durchgeführt werden kann. Hieraus ergibt sich eine einfachere Handhabung und Montage im Vergleich zu einer konventionellen Permanentmagnetmaschine.

Insbesondere dann, wenn nur ein Teil der von der supraleitenden Spule eingeschlossenen Fläche mit dem wenigstens einen Hochtemperatursupraleitermaterialblock belegt ist, kann man nach dem ersten Aufmagnetisieren des Hochtemperatursupraleitermaterialblocks, beispielsweise bei maximalen Erregerstrom, das Polfeld durch die Bestromung der supraleitenden Spulen regeln beziehungsweise beeinflussen. Auf diese Weise wird eine regelbare permanentmagneterregte Maschine realisiert, mit der neben dem Nennbetrieb auch über- beziehungsweise untererregter Betrieb möglich ist. Der regelbare Bereich wird durch den mit Hochtemperatursupraleitermaterial belegten Flächenanteil und den bei der Aufmagnetisierung eingesetzten Spulenstrom bestimmt.

Besonders vorteilhaft ist es zudem, dass zur Entmagnetisierung des Hochtemperatursupraleitermaterialblocks, beispielsweise für Wartungszwecke, das Heizmittel verwendet werden kann, um den Hochtemperatursupraleitermaterialblock kurzzeitig über seine kritische Temperatur zu erwärmen. Dabei muss selbstverständlich der Erregerstrom durch die supraleitenden Spulen abgeschaltet sein. Gegenüber echten permanentmagneterregenden Maschinen ist die Möglichkeit der Entmagnetisierung des Bauteils, insbesondere des Rotors, ein wesentlicher Vorteil.

Wie bereits erwähnt, ist die erfindungsgemäße Maschine auch ohne die Nutzung der supraleitenden Spulen betreibbar, solange die aufmagnetisierten Hochtemperatursupraleitermaterialblöcke der Maschine kalt gehalten werden, das bedeutet, unterhalb der kritischen Temperatur des Hochtemperatursupraleitermaterial und unterhalb der Temperatur, bei der thermisch aktiviertes Flusskriechen zu einer signifikanten Bewegung der Flusslinien führt. Dies ermöglicht es insbesondere, die Maschine auch bei höherer Temperatur, bei der Verwendung von YBCO beispielsweise bis zu ca. 65 K, zu betreiben, was beispielsweise ein effizienteres Betriebskonzept, insbesondere im Hinblick auf eine vorgesehene Kühleinrichtung, ermöglicht. Vorzugsweise ist der Hochtemperatursupraleitermaterialblock mit dem restlichen Bauteil, insbesondere dem restlichen Rotor, über eine definierte, schwache thermische Ankopplung verbunden. Durch eine solche definierte thermische Ankopplung des Hochtemperatursupraleitermaterials an das kalte Bauteil (mit wohldefinierter geringer thermischer Leitfähigkeit) werden das Bauteil und die supraleitende Spule während der Erwärmung des Hochtemperatursupraleitermaterialblocks durch das Heizmittel kaum miterwärmt. Konkrete Werte für die thermische Leitfähigkeit der Ankopplung, konkret also eines Ankopplungsmaterials, ergeben sich aus den speziellen Anforderungen und Ausgestaltungen.

Ferner kann vorgesehen sein, dass der Hochtemperatursupraleitermaterialblock im Bereich des Spulenkerns angeordnet ist, also letztlich innerhalb des von der supraleitenden Spule eingeschlossenen Bereichs. Dabei kann, wie bereits erwähnt, vorgesehen sein, dass nicht der gesamte von der supraleitenden Spule eingeschlossene Bereich durch das Hochtemperatursupraleitermaterial des Hochtemperatursupraleitermaterialblocks oder mehrerer Hochtemperatursupraleitermaterialblöcke ausgefüllt wird, sondern dass übliches Polkernmaterial zusätzlich vorhanden ist, beispielsweise magnetisches Material wie Eisen oder unmagnetisches Material. Dies bietet insbesondere dem von der supraleitenden Spule erzeugten Fluss auch dann noch Raum, wenn der Hochtemperatursupraleitermaterialblock supraleitend ist und mithin weiteren magnetischen Fluss verdrängt, so dass sich die bereits erwähnte regelbare Maschine ergibt. Über den Erregerstrom kann dann eingestellt werden, welcher Fluss genau an den Polen vorliegen soll. Beispielsweise kann in axialer Richtung des Rotors eine Mehrzahl von Hochtemperatursupraleitermaterialblöcken vorgesehen werden, die immer durch Blöcke aus einem Polkernmaterial unterbrochen sind und gegebenenfalls sogar über die thermische Ankopplung getrennt gehaltert werden. Verschiedene Ausgestaltungen sind hier denkbar. Es sei an dieser Stelle noch angemerkt, dass sich der Hochtemperatursupraleitermaterialblock nicht unbedingt in dem von der supraleitenden Spule umschlossenen Bereich befinden muss, sondern dass es auch denkbar ist, diesen an anderen Stellen des magnetischen Pfades im Bauteil unterzubringen.

Wie bereits erwähnt, kann vorgesehen sein, dass wenigstens zwei Hochtemperatursupraleitermaterialblöcke für jede supraleitende Spule vorgesehen sind. Dabei ist es besonders vorteilhaft, wenn jedem Hochtemperatursupraleitermaterialblock ein eigenes, getrennt ansteuerbares Heizmittel zugeordnet ist. Es sind dann also mehrere Hochtemperatursupraleitermaterialblöcke vorhanden, die jeweils einzeln beheizbar und kühlbar sind. Dies ermöglicht es beispielsweise, den im Bulkmaterial der Hochtemperatursupraleiterblöcke "eingefrorenen" magnetischen Fluss deutlich über den mit der supraleitenden Spule erreichbaren Fluss zu steigern. Hierzu werden in geeigneter Reihenfolge die supraleitende Spule bestromt/nicht bestromt und die Hochtemperatursupraleitermaterialblöcke beheizt/gekühlt. Auf diese Weise kann abhängig vom maximal im Hochtemperatursupraleiter einfrierbaren magnetischen Fluss und der Anzahl n der einzeln thermisch ansteuerbaren Hochtemperatursupraleitermaterialblöcke, die der Spule zugeordnet sind, bis zum n-fachen des mit der Spule erzeugbaren Flusses im Bauteil "eingefroren" werden.

Dies sei anhand eines Beispiels näher erläutert. Dabei sei von einem Rotor mit drei Hochtemperatursupraleitermaterialblöcken für jede supraleitende Spule ausgegangen, von denen jeder ein Drittel des von der supraleitenden Spule eingeschlossenen Bereichs belegt.

Hierbei wird zunächst der erste Hochtemperatursupraleitermaterialblock auf eine Temperatur oberhalb seiner kritischen Temperatur geheizt, während der zweite und der dritte Hochtemperatursupraleitermaterialblock weiterhin supraleitend (kalt) sind. Die supraleitende Spule wird bestromt. Dies führt dazu, dass der Fluss der supraleitenden Spule von dem zweiten und dem dritten Hochtemperatursupraleitermaterialblock verdrängt wird, so dass der gesamte magnetische Fluss der supraleitenden Spule den ersten Hochtemperatursupraleitermaterialblock durchdringt. Durch ein Ausschalten des Heizmittels wird der erste Hochtemperatursupraleitermaterialblock abgekühlt, so dass der gesamte magnetische Fluss der supraleitenden Spule in dem ersten Hochtemperatursupraleitermaterialblock festgepinnt ("eingefroren") ist. Optional kann nun der Erregerstrom durch die supraleitende Spule ausgeschaltet werden.

Sodann wird der zweite Hochtemperatursupraleitermaterialblock auf eine Temperatur oberhalb seiner kritischen Temperatur mittels des Heizmittels erwärmt und der erste Hochtemperatursupraleitermaterialblock und der dritte Hochtemperatursupraleitermaterialblock werden supraleitend (kalt). Wird nun wiederum die supraleitende Spule bestromt, so wird der magnetische Fluss der supraleitenden Spule in diesem Fall durch den ersten Hochtemperatursupraleitermaterialblock und den dritten Hochtemperatursupraleitermaterialblock verdrängt, so dass der gesamte Spulenfluss den zweiten Hochtemperatursupraleitermaterialblock durchdringt. Wird dieser nun wiederum durch Ausschalten des Heizmittels abgekühlt, wird der gesamte magnetische Fluss der Spule auch in dem zweiten Hochtemperatursupraleitermaterialblock "eingefroren". Optional kann nun wiederum der Strom durch die supraleitende Spule ausgeschaltet werden.

Schließlich wird mittels des entsprechenden Heizmittels auch der dritte Hochtemperatursupraleitermaterialblock auf eine Temperatur oberhalb seiner kritischen Temperatur erhitzt, während der erste und der zweite Hochtemperatursupraleitermaterialblock supraleitend, also kalt, bleiben. Die supraleitende Spule wird bestromt, so dass der Fluss der Spule nun durch den ersten und den zweiten Hochtemperatursupraleitermaterialblock verdrängt wird und der gesamte Spulenfluss den dritten Hochtemperatursupraleitermaterialblock durchdringt. Auch dieser wird nun durch Deaktivieren des Heizmittels abgekühlt, so dass der gesamte magnetische Fluss der Spule im dritten Hochtemperatursupraleitermaterialblock "eingefroren" wird, wonach der Strom durch die supraleitende Spule ausgeschaltet werden kann.

Im Ergebnis ist nun in den drei Hochtemperatursupraleitermaterialblöcken in der Summe der dreifache magnetische Fluss der supraleitenden Spule eingefroren.

Jedoch sind auch andere Möglichkeiten denkbar, derartige getrennt heizbare Hochtemperatursupraleitermaterialblöcke einzusetzen. In einem weiteren Ausführungsbeispiel ist ein Teil des von der Spule eingeschlossenen Bereichs nicht durch Hochtemperatursupraleitermaterialblöcke belegt. Hierdurch ist es möglich, wie bereits erwähnt, eine Maschine zu realisieren, die sich nicht nur wie eine permanentmagneterregte Maschine verhält, sondern zusätzlich noch eine regelbare Erregung besitzt. Bei einer geeigneten Auslegung, also insbesondere einer geeigneten Wahl des durch die Hochtemperatursupraleitermaterialblöcke belegten Bereichsanteils, ist eine Maschine realisierbar, die neben ihrem Nennbetrieb auch für über- und untererregten Betrieb geeignet ist. Dies sei wiederum anhand eines Beispiels dargelegt.

Sei in einem konkreten Ausführungsbeispiel ein Drittel des Bereichs, der von der supraleitenden Spule umschlossen wird, nicht durch Hochtemperatursupraleitermaterial belegt, während die beiden verbleibenden Drittel des Bereichs jeweils mit einem (eventuell auch aus mehreren Segmenten zusammengesetzten) beheizbaren Hochtemperatursupraleitermaterialblock belegt sind. Abweichend von dem oben diskutierten konkreten Ausführuhgsbeispiel kann jeweils der halbe maximal mögliche magnetische Fluss der Spule in den beiden Hochtemperatursupraleitermaterialblöcken festgepinnt werden. In der Summe ist somit ein maximal möglicher magnetischer Fluss der Spule im Bulkmaterial "eingefroren". Betreibt man nun die supraleitende Spule zusätzlich, und zwar bipolar, so kann die Erregung vom Fluss "0" bis hin zum "doppelten maximalen magnetischen Fluss der supraleitenden Spule" geregelt werden.

Zweckmäßig hat es sich erwiesen, als Material für den Hochtemperatursupraleitermaterialblock YBCO oder einen 123-Supraleiter umfassend ein anderes Metall oder eine Kombination aus mehreren Metallen der seltenen Erden (z. B. Y, Sm, Nd, Eu, Gd) zu verwenden, wie z. B. NdBaCuO, SmBaCuO oder GdBaCuO. Auch MgB₂ ist als Bulkmaterial denkbar. Wie bereits dargelegt, ist die Flusslinienverankerung in YBCO-Bulkmaterial auch noch bei Temperaturen bis zu ungefähr 65K sehr effektiv. Werden andere seltene Erden verwendet, kann diese Temperatur sogar noch etwas erhöht werden.

Neben der elektrischen Maschine betrifft die vorliegende Erfindung auch ein Verfahren zum Betrieb einer erfindungsgemäßen elektrischen Maschine, wobei bei bestromter, supraleitender Spule durch das Heizmittel die Temperatur des Hochtemperatursupraleitermaterialblocks über die kritische Temperatur des Materials des Hochtemperatursupraleitermaterialblocks erhöht wird, wonach das Heizmittel deaktiviert wird. Auf diese Weise wird, wie bereits dargelegt wurde, ein "Einfrieren" des magnetischen Flusses in dem Hochtemperatursupraleitermaterialblock ermöglicht. Durch die Deaktivierung des Heizmittels wird der Hochtemperatursupraleitermaterialblock unterhalb seiner kritischen Temperatur abgekühlt und der magnetische Fluss wird festgepinnt. Sodann kann im Übrigen auch die supraleitende Spule wieder ausgeschaltet werden. Sämtliche Ausführungen bezüglich der elektrischen Maschine lassen sich analog auf das erfindungsgemäße Verfahren übertragen.

In weiterer Ausgestaltung des erfindungsgemäßen Verfahrens kann vorgesehen sein, dass bei mehreren vorgesehenen Hochtemperatursupraleitermaterialblöcken für jede supraleitende Spule mit zugeordneten, separat ansteuerbaren Heizmitteln die soeben genannten Schritte, wobei bei bestromter, supraleitender Spule durch das Heizmittel die Temperatur des Hochtemperatursupraleitermaterialblocks über die kritische Temperatur des Materials des Hochtemperatursupraleitermaterialblocks erhöht wird, wonach das Heizmittel deaktiviert wird, sukzessive für alle Hochtemperatursupraleitermaterialblöcke durchgeführt werden, wobei die Temperatur gerade nicht zu magnetisierender Hochtemperatursupraleitermaterialblöcke unterhalb der kritischen Temperatur des Materials der Hochtemperatursupraleitermaterialblöcke liegt. Dieses Vorgehen wurde bereits bezüglich der elektrischen Maschine ausführlich erläutert, so dass mithin grundsätzlich vorgesehen sein kann, dass die Spule bei dem Magnetisierungsprozess mit ihrem Maximalstrom betrieben wird, so dass beispielsweise eine permanent eingespeicherte Magnetisierung erzeugbar ist, die einem Vielfachen des mit der supraleitenden Spule alleine erzeugbaren magnetischen Flusses entspricht. Denkbar ist es jedoch auch, dass die Spule mit nur einem der Zahl der Hochtemperatursupraleitermaterialblöcke entsprechenden Anteil des Maximalstroms betrieben wird, nachdem am Ende die Hochtemperatursupraleitermaterialblöcke insgesamt den maximal durch die supraleitende Spule erzeugbaren magnetischen Fluss enthalten, so dass durch zusätzliche, bipolare Bestromung der supraleitenden Spule jeder Wert des magnetischen Flusses von keinem magnetischen Fluss bis zum Doppelten des maximal durch die supraleitende Spule erzeugbaren magnetischen Flusses erzeugt werden kann. Hierbei ist es besonders zweckmäßig, wenn nicht der gesamte durch die supraleitende Spule eingeschlossene Bereich durch die Hochtemperatursupraleitermaterialblöcke aufgefüllt ist, wobei dann zu beachten ist, dass sich der Fluss der Spule auch beim Festpinnen aufteilen wird und der Erregerstrom entsprechend angepasst werden muss.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine Prinzipskizze einer elektrischen Maschine gemäß der vorliegenden Erfindung, und
- Fig. 2: eine Aufsicht auf einen Pol der elektrischen Maschine.

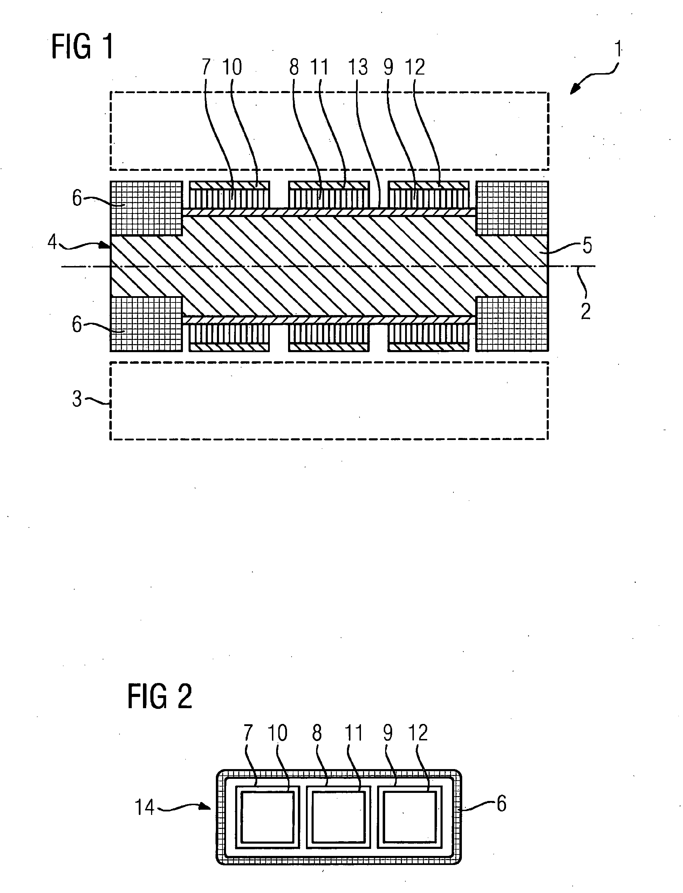

Fig. 1 zeigt in Form einer Prinzipskizze eine erfindungsgemäße elektrische Maschine 1. Wie grundsätzlich bekannt, umfasst die Maschine 1 einen um eine Rotationsachse 2 gegen einen hier nur angedeuteten Stator 3 drehbaren Rotor 4, der im vorliegenden Ausführungsbeispiel Rotorpole tragen soll, von denen im gezeigten Längsschnitt zwei zu sehen sind. Der Rotor 4 umfasst einen Rotorkörper 5, der hier aus ferromagnetischem Material besteht und supraleitende Spulen 6 als Polwicklungen trägt. Ein Teil des von den Spulen 6 jeweils eingeschlossenen Bereichs ist dabei durch das Material des Rotorkörpers 5 aufgefüllt und nicht von Hochtemperatursupraleiter-Bulkmaterial bedeckt.

Im übrigen Anteil des durch die Spulen 6 eingeschlossenen Bereichs sind drei Hochtemperatursupraleitermaterialblöcke 7, 8, 9 angeordnet, denen jeweils ein separat ansteuerbares Heizmittel 10, 11, 12 zugeordnet ist. Mit dem Rotorkörper 5 sind die Hochtemperatursupraleitermaterialblöcke 7, 8, 9 über eine schwache, thermische Ankopplung 13 verbunden, beispielsweise ein Ankopplungsmaterial mit einer definierten, geringen thermischen Leitfähigkeit. Dies ermöglicht es, kurzzeitig die Hochtemperatursupraleitermaterialblöcke 7, 8, 9 mittels der Heizmittel 10, 11, 12 auf eine Temperatur oberhalb der kritischen Temperatur ihres Hochtemperatursupraleitermaterials zu bringen, ohne einen Verlust der Supraleitung der Spulen 6 befürchten zu müssen. Dennoch werden bei Deaktivieren der Heizmittel 10, 11, 12 die Hochtemperatursupraleitermaterialblöcke 7, 8, 9 aufgrund der hier nicht näher gezeigten Kühleinrichtung für den Rotor 4 wieder unter die kritische Temperatur abgekühlt.

Als Material für die Hochtemperatursupraleitermaterialblöcke 7, 8, 9 wurde vorliegend YBCO verwendet.

Fig. 2 zeigt eine Aufsicht auf einen Pol 14 des Rotors 4. Deutlich erkennbar sind in dem durch die Spule 6 eingeschlossenen Bereich die Hochtemperatursupraleitermaterialblöcke 7, 8, 9 mit ihren Heizmitteln 10, 11, 12.

Dabei sei an dieser Stelle noch angemerkt, dass auch Ausgestaltungen denkbar sind, bei denen das Material des Polkörpers 5 zwischen die Hochtemperatursupraleitermaterialblöcke 7, 8, 9 hineinragt, so dass sich eine "zahnartige" Struktur ergibt.

Die Grundidee ist es nun, einen durch die Spule 6 erzeugten magnetischen Fluss in den Hochtemperatursupraleitermaterialblöcken 7, 8, 9 einzuspeichern. Dies kann für jeden der Hochtemperatursupraleitermaterialblöcke 7, 8, 9 aufgrund der ihm speziell zugeordneten Heizung 10, 11 beziehungsweise 12 einzeln geschehen, so dass es beispielsweise denkbar ist, in alle drei Hochtemperatursupraleitermaterialblöcke 7, 8, 9 einen maximal möglichen magnetischen Fluss der Spule 6 einzuspeichern. Auf diese Weise kann ein permanent vorhandener magnetischer Fluss erzeugt werden, der größer als der maximal mit der supraleitenden Spule 6 erzeugbare Fluss ist.

Um einen magnetischen Fluss in einem Hochtemperatursupraleitermaterialblock 7, 8 oder 9 festzupinnen und somit "einzufrieren", wird dieser durch das Heizmittel 10, 11 oder 12 auf eine Temperatur gebracht, die höher als die kritische Temperatur ist, während die anderen Hochtemperatursupraleitermaterialblöcke 7, 8, 9 und die supraleitende Spule 6 unterhalb ihrer jeweiligen kritischen Temperatur bleiben. Fluss wird somit aus den anderen Hochtemperatursupraleitermaterialblöcken 7, 8, 9 verdrängt und nur der erwärmte Hochtemperatursupraleitermaterialblock 7, 8 oder 9 wird vom Fluss durchströmt, sobald die Spule 6 mit dem gewünschten Erregerstrom bestromt ist. Sodann kann das entsprechende Heizmittel 10, 11 oder 12 wieder ausgeschaltet werden und der entsprechende Hochtemperatursupraleitermaterialblock 7, 8 oder 9 kühlt wieder ab, so dass der magnetische Fluss festgepinnt wird.

Im vorliegenden Ausführungsbeispiel kann nun vorgesehen werden, dass in den Hochtemperatursupraleitermaterialblöcken 7, 8, 9 jeweils ein Drittel des maximal durch die Spule 6 erzeugbaren magnetischen Flusses eingespeichert wird, so dass diese insgesamt den maximal mit der Spule 6 erzeugbaren magnetischen Fluss enthalten. Nachdem ein Teil des Bereiches, der durch die Spule 6 umschlossen wird, durch das Material des Rotorkörpers 5 aufgefüllt ist, bildet sich ein weiterer Weg für nun zusätzlich von der Spule 6 erzeugte magnetische Flüsse, so dass über eine entsprechende Bestromung der Spule 6 der magnetische Fluss der Pole von 0 bis zum Doppelten des durch die Spule maximal erzeugbaren magnetischen Flusses geregelt werden kann.

In anderen Ausgestaltungen ist es auch möglich, den gesamten durch die Spule 6 umschlossenen Bereich mit Hochtemperatursupraleitermaterialblöcken 7, 8, 9 aufzufüllen, um so bereits grundsätzlich den maximal durch die Spule 6 erzeugbaren magnetischen Fluss in jeden der Hochtemperatursupraleitermaterialblöcke 7, 8, 9 einspeichern zu können. Denn wird die Spule 6 betrieben, wenn sich in dem von ihr umschlossenen Bereich nur Hochtemperatursupraleitermaterialblöcke 7, 8, 9 befinden, von denen nur einer nicht supraleitend ist, kann nur durch diesen einen, nicht supraleitenden Hochtemperatursupraleitermaterialblock der gesamte Fluss, der von der Spule 6 erzeugt wird, fließen und mithin dort festgepinnt werden.

Im gezeigten Ausführungsbeispiel wurden nur beispielshalber drei Hochtemperatursupraleitermaterialblöcke 7, 8, 9 gezeigt, selbstverständlich sind auch andere Anzahlen möglich, beispielsweise 5 Hochtemperatursupraleitermaterialblöcke.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, wie sie durch die beigefügten Patentansprüche definiert wird.

## Patentansprüche

1. Elektrische Maschine (1), umfassend als Bauteile einen Stator (3) und einen gegen den Stator (3) drehbaren Rotor (4), wobei die Pole (14) eines Bauteils, insbesondere des Rotors (4), supraleitende Spulen (6) zur Erzeugung eines magnetischen Flusses umfassen, **dadurch gekennzeichnet, dass** in dem Pfad des magnetischen Flusses wenigstens ein Hochtemperatursupraleitermaterialblock (7, 8, 9) mit einem diesem zugeordneten, zur zeitweisen Erhöhung der Temperatur des Hochtemperatursupraleitermaterialblocks (7, 8, 9) über die kritische Temperatur des Materials des Hochtemperatursupraleitermaterialblocks (7, 8, 9) bei supraleitender Spule (6) ausgebildeten Heizmittel (10, 11, 12) angeordnet ist, wobei für jede supraleitende Spule (6) wenigstens zwei Hochtemperatursupraleitermaterialblöcke (7, 8, 9) vorgesehen sind und jedem Hochtemperatursupraleitermaterialblock (7, 8, 9) ein eigenes, getrennt ansteuerbares Heizmittel (10, 11, 12) zugeordnet ist.

2. Maschine nach Anspruch 1, **dadurch gekennzeichnet, dass** der Hochtemperatursupraleitermaterialblock (7, 8, 9) an das restliche Bauteil über eine definierte, schwache thermische Ankopplung (13) verbunden ist.

3. Maschine nach Anspruch 1 oder 2, **dadurch gekennzeichnet, dass** der Hochtemperatursupraleitermaterialblock (7, 8, 9) im Bereich des Spulenkerns angeordnet ist.

4. Maschine nach einem der vorangehenden Ansprüche, **dadurch gekennzeichnet, dass** als Material für den Hochtemperatursupraleitermaterialblock (7, 8, 9) YBCO oder ein 123-Supraleiter umfassend ein anderes Metall oder eine Kombination aus mehreren Metallen der seltenen Erden oder Magnesiumdiborid verwendet wird.

5. Verfahren zum Betrieb einer elektrischen Maschine nach einem der vorangehenden Ansprüche, wobei a) bei bestromter, supraleitender Spule (6) durch das Heizmittel (10, 11, 12) die Temperatur des Hochtemperatursupraleitermaterialblocks (7, 8, 9) über die kritische Temperatur des Materials des Hochtemperatursupraleitermaterialblocks (7, 8, 9) erhöht wird, wonach b) das Heizmittel (10, 11, 12) deaktiviert wird, wobei bei mehreren vorgesehenen Hochtemperatursupraleitermaterialblöcken (7, 8, 9) mit zugeordneten, separat ansteuerbaren Heizmitteln (10, 11, 12) die Schritte a) und b) sukzessive für alle Hochtemperatursupraleitermaterialblöcke (7, 8, 9) durchgeführt werden, wobei die Temperatur gerade nicht zu magnetisierender Hochtemperatursupraleitermaterialblöcke (7, 8, 9) unterhalb der kritischen Temperatur des Materials der Hochtemperatursupraleitermaterialblöcke (7, 8, 9) liegt.

6. Verfahren nach Anspruch 5, **dadurch gekennzeichnet, dass** die Spule (6) mit nur einem der Zahl der Hochtemperatursupraleitermaterialblöcke (7, 8, 9) entsprechenden Anteil des Maximalstroms betrieben wird.

7. Verfahren nach Anspruch 5, **dadurch gekennzeichnet, dass** die Spule (6) bei dem Magnetisierungsprozess mit ihrem Maximalstrom betrieben wird.

## Claims

1. Electric machine (1), including, as components, a stator (3) and a rotor (4) which can be rotated in relation to the stator (3), wherein the poles (14) of one component, in particular of the rotor (4), comprise superconducting coils (6) for generating a magnetic flux, **characterised in that**, at least one high-temperature superconducting material block (7, 8, 9) with a heating means (10, 11, 12), which is associated with said high-temperature superconducting material block and is designed to temporarily increase the temperature of the high-temperature superconducting material block (7, 8, 9) above the critical temperature of the material of the high-temperature superconducting material block (7, 8, 9) in the superconducting coil (6), is arranged in the path of the magnetic flux, wherein at least two high-temperature superconducting material blocks (7, 8, 9) are provided for each superconducting coil (6) and a an independent, separately controllable heating means (10, 11, 12) is assigned to each high-temperature superconducting material block (7, 8, 9).

2. Machine according to claim 1, **characterised in that** the high-temperature superconducting material block (7, 8, 9) is connected to the remainder of the component by way of a defined, weak thermal coupling (13).

3. Machine according to claim 1 or 2, **characterised in that** the high-temperature superconducting material block (7, 8, 9) is arranged in the region of the coil core.

4. Machine according to one of the preceding claims, **characterised in that** YBCO or a 123 superconductor comprising another metal or a combination of several rare earth metals or magnesium diboride is used as material for the high-temperature superconducting material block (7, 8, 9).

5. Method for operating an electric machine according to one of the preceding claims, wherein a) with an energised, superconducting coil (6), the temperature of the high-temperature superconducting material block (7, 8, 9) is increased by the heating means (10, 11, 12) to above the critical temperature of the material of the high-temperature superconducting material block (7, 8, 9), after which b) the heating means (10, 11, 12) is deactivated, wherein with several provided high-temperature superconducting material blocks (7, 8, 9) with associated, separately controllable heating means (10, 11, 12), the steps a) and b) are implemented successively for all high-temperature superconducting material blocks (7, 8, 9), wherein the temperature of high-temperature superconducting material blocks (7, 8, 9) not currently to be magnetised lies below the critical temperature of the material of the high-temperature superconducting material blocks (7, 8, 9).

6. Method according to claim 5, **characterised in that** the coil (6) is operated with just one portion of the maximum current which corresponds to the number of high-temperature superconducting material blocks (7, 8, 9).

7. Method according to claim 5, **characterised in that** the coil (6) is operated with its maximum current during the magnetisation process.

## Revendications

1. Machine ( 1 ) électrique, comprenant comme partie constitutive un stator ( 3 ) et un rotor ( 4 ) pouvant tourner par rapport au stator ( 3 ) les pôles ( 14 ) d'une partie constitutive, notamment du rotor ( 4 ) comprenant des bobines ( 6 ) supraconductrices pour la production d'un flux magnétique, **caractérisée en ce qu'**il est monté dans le chemin du flux magnétique au moins un bloc ( 7, 8, 9 ) en matière supraconductrice à haute température ayant, associé à celui-ci, pour élever de temps en temps la température du bloc ( 7, 8, 9 ) de matière supraconductrice à haute température au-dessus de la température critique de la matière du bloc ( 7, 8, 9 ) de matière supraconductrice à haute température, un moyen ( 10, 11, 12 ) de chauffage près de la bobine ( 6 ) supraconductrice, au moins deux blocs ( 7, 8, 9 ) de matière supraconductrice à haute température étant prévus pour chaque bobine ( 6 ) supraconductrice et un moyen ( 10, 11 12 ) de chauffage propre et pouvant être commandé séparément est associé à chaque bloc ( 7, 8, 9 ) de matière supraconductrice à haute température.

2. Machine suivant la revendication 1, **caractérisée en ce que** le bloc ( 7, 8, 9 ) de matière supraconductrice à haute température est relié à la partie constitutive restante par un couplage ( 13 ) thermique faible défini.

3. Machine suivant la revendication 1 ou 2, **caractérisée en ce que** le bloc ( 7, 8, 9 ) de matière supraconductrice à haute température est disposé dans la partie du noyau de la bobine.

4. Machine suivant l'une des revendications précédentes, **caractérisée en ce qu'**il est utilisé comme matière pour le bloc ( 7, 8, 9 ) de matière supraconductrice à haute température du YBCO ou un supraconducteur 123 comprenant un autre métal ou une combinaison de plusieurs métaux de terres rares ou du diborure de magnésium.

5. Procédé pour faire fonctionner une machine électrique suivant l'une des revendications précédentes, dans lequel a ) lorsque la bobine ( 6 ) supraconductrice est alimentée en courant, on élève par le moyen ( 10, 11, 12 ) de chauffage la température du bloc ( 7, 8, 9 ) de matière supraconductrice à haute température au-dessus de la température critique de la matière du bloc ( 7, 8, 9 ) de matière supraconductrice à haute température, puis b) on désactive le moyen ( 10, 11, 12 ) de chauffage, dans lequel lorsqu'il y a plusieurs blocs ( 7, 8, 9 ) de matière supraconductrice à haute température qui sont prévus et qui ont des moyens ( 10, 11, 12 ) de chauffage associés pouvant être commandés séparément, on effectue les stades a) et b) successivement pour tous les blocs ( 7, 8, 9 ) de matière supraconductrice à haute température, la température des blocs ( 7, 8, 9 ) de matière supraconductrice à haute température précisément à ne pas aimanter étant inférieure à la température critique de la matière des blocs ( 7, 8, 9 ) de matière supraconductrice à haute température.

6. Procédé suivant la revendication 5, **caractérisé en ce qu'**on fait fonctionner la bobine ( 6 ) avec seulement une proportion du courant maximum correspondant au nombre des blocs ( 7, 8, 9 ) de matière supraconductrice à haute température.

7. Procédé suivant la revendication 5, **caractérisé en ce qu'**on fait fonctionner la bobine ( 6 ) lors de l'opération d'aimantation à son courant maximum.
